# FASCICULE DE BREVET EUROPEEN

(11) **EP 2 924 716 B1**
(45) Date de publication et mention de la délivrance du brevet: **09.01.2019**
(21) Numéro de dépôt: 15160821.3
(22) Date de dépôt: 25.03.2015
(51) Int. Cl.: H01L 21/308, H01L 21/311

(54) **PROCÉDÉ DE STRUCTURATION ET DE TRANSFERT D'UN MASQUE DANS UN SUBSTRAT**
STRUKTURIERUNGS- UND TRANSFERVERFAHREN EINER MASKE IN EIN SUBSTRAT
METHOD FOR STRUCTURING AND TRANSFERRING A MASK IN A SUBSTRATE

(30) Priorité: 25.03.2014 FR 1452514
(43) Date de publication de la demande: 30.09.2015
(73) Titulaire: Université de Technologie de Troyes, 10010 Troyes Cédex (FR)
(72) Inventeur: Lerondel, Gilles, 10800 St Julien les Villas (FR); Mc Murty, Stefan, 10010 TROYES CEDEX (FR)
(74) Mandataire: Gauchet, Fabien Roland

(56) Documents cités:
- WO-A1-2010/130963
- KR-A- 20130 141 809
- CHEN P H ET AL: "GaN-Based Light-Emitting Diodes With Pillar Structures Around the Mesa Region", IEEE JOURNAL OF QUANTUM ELECTRONICS, IEEE SERVICE CENTER, PISCATAWAY, NJ, USA, vol. 46, no. 7, 1 juillet 2010 (2010-07-01), pages 1066-1071, XP011306501, ISSN: 0018-9197
- ZHANG W ET AL: "Rough glass by 3d texture transfer for silicon thin film solar cells", PHYSICA STATUS SOLIDI C WILEY-VCH VERLAG GMBH GERMANY, vol. 7, no. 3-4, avril 2010 (2010-04), pages 1120-1123, XP002733007, ISSN: 1862-6351
- LEE D Y ET AL: "Etch characteristics of indium zinc oxide thin films using inductively coupled plasma of a Cl2/Ar gas", THIN SOLID FILMS, ELSEVIER-SEQUOIA S.A. LAUSANNE, CH, vol. 517, no. 14, 29 mai 2009 (2009-05-29) , pages 4047-4051, XP026094857, ISSN: 0040-6090, DOI: 10.1016/J.TSF.2009.01.136 [extrait le 2009-02-04]

## Description

### DOMAINE TECHNIQUE DE L'INVENTION

L'invention se rapporte au domaine des micro-, meso- et nano-objets. Plus particulièrement l'invention concerne un procédé de structuration haute résolution et de transfert d'un masque en ZnO dans un substrat, par gravure sèche.

### ETAT DE LA TECHNIQUE ANTERIEURE

Les techniques connues notamment dans le domaine de la nano-fabrication mettent généralement en oeuvre un masque polymérique, en verre, en nitrure, en SiO₂ ou encore métallique, qui peut être structuré directement ou indirectement par une technique de lithographie telle que la photolithographie, la lithographie électronique ou le nanoimprint. Par indirectement on entend à l'aide d'une couche supplémentaire par exemple de résine elle-même nano-structurée.

Habituellement les masques facilement gravés par voie chimique liquide le sont également par gravure sèche (sélectivité par rapport au silicium inférieure à l'unité).

**A** titre d'exemple le PMMA (polyméthacrylate de méthyle) est utilisé car il est facilement structuré par lithographie électronique (haute résolution) et facile à dissoudre par une attaque chimique liquide. Malheureusement il est aussi facilement gravé par gravure ionique réactive (RIE). Son emploi en est donc limité. On utilise par ailleurs le HSQ, plus résistant, mais qui ne permet pas de créer des structures très profondes par RIE.

Il en est de même le SiO₂ qui présente une sélectivité chimique égale à deux.

A ce jour les seuls masques permettant d'avoir de bons rapports de forme c'est-à-dire de l'ordre de 4 à 10 (pour des motifs microniques) sont des masques métalliques. Le rapport de forme est couramment défini comme le ratio entre la hauteur ou profondeur d'un élément d'un motif et sa plus grande dimension mesurée parallèlement au plan du substrat. L'inconvénient principal de ces masques réside en ce que les solutions permettant de les dissoudre peuvent altérer les nanostructures réalisées.

Un problème récurrent et non résolu concerne la dissolution du masque pour la réalisation de nanostructures profondes ou bien dans des matériaux difficiles à graver. De bons rapports de forme sont recherchés.

Le document KR 2013 014 1809 décrit la structuration d'un substrat à base de verre à l'aide d'une couche de ZnO structurée agissant comme masque. Le ZnO est directement déposé sur le substrat, et est structuré par gravure sèche pour créer le masque.

### EXPOSE DE L'INVENTION

L'invention vise à remédier aux inconvénients de l'état de la technique et notamment à proposer un procédé de structuration haute résolution et de transfert d'un masque dans un substrat.

Selon un mode de réalisation de l'invention, ledit masque est constitué de ZnO structuré et est autosupporté et le procédé, défini par la revendication 1, comprend les étapes consistant à : -préparer un masque autosupporté ; - disposer le masque autosupporté sur un substrat à structurer ; -transférer le masque autosupporté dans ledit substrat.

De façon plus précise, et selon une première variante la préparation dudit masque autosupporté comprend les étapes suivantes : - déposer une couche mince constituée de ZnO sur un premier substrat ; - structurer ladite couche de ZnO ; - infiltrer la couche de ZnO par une couche mince de polymère ; - séparer ledit masque autosupporté vis-à-vis dudit premier substrat.

Selon une deuxième variante, la préparation dudit masque autosupporté comprend les étapes suivantes : - déposer une couche mince comprenant des nanostructures de ZnO incluses dans un polymère, sur un premier substrat ; -faire durcir ledit polymère ; -séparer le masque autosupporté vis-à-vis du premier substrat.

Avantageusement, le transfert du ZnO structuré dans le substrat est réalisé par gravure sèche.

Préférentiellement ledit substrat est réalisé en un matériau tel que le Silicium, le verre ou le quartz.

Le transfert peut être réalisé par gravure sèche fluorée dans du Silicium.

Alternativement, mais ne faisant pas partie de l'invention, ledit procédé consiste à : - déposer une couche d'épaisseur uniforme sur tout ou partie dudit de la surface dudit substrat ; - structurer la couche de ZnO ; - transférer la couche structurée dans ledit substrat afin de réaliser un substrat structuré.

Matériau multi-fonctionnel, le ZnO est utilisé pour ses propriétés intrinsèques électriques, optiques et/ou mécaniques. cela permet d'utiliser certaines de ces propriétés physico-chimiques, notamment mais pas uniquement dans le domaine de la nano-fabrication, afin de créer des nano-structures à fort rapport de forme ou encore dans des matériaux réputés difficiles à graver.

Le procédé présente notamment l'avantage d'un faible taux de pulvérisation du ZnO (sélectivité élevée). De plus le masque en ZnO présente la particularité d'une dissolution aisée par voie chimique.

La structuration du masque est réalisée directement, de préférence par photo dissolution du ZnO.

Plus précisément, ladite photodissolution est réalisée par lithographie interférentielle.

Alternativement, mais ne faisant pas partie de l'invention, ladite structuration est indirecte et comprend : - le dépôt d'une couche électro ou photosensible sur la surface libre de la couche de ZnO ; - la structuration de ladite couche par lithographie ; - l'attaque chimique de la couche de ZnO.

Ladite lithographie peut être de type électronique ou optique.

Alternativement, mais ne faisant pas partie de l'invention, ledit masque est constitué de micro et/ou de méso et/ou de nanostructures de ZnO déposées par voie chimique ou physique sur ledit substrat avant d'être transférées dans ledit substrat.

### BREVE DESCRIPTION DES FIGURES

D'autres caractéristiques, détails et avantages de l'invention ressortiront à la lecture de la description qui suit, en référence aux figures annexées, qui illustrent :
- la figure 1, un schéma d'ensemble montrant notamment les étapes du procédé de structuration selon l'invention ;
- la figure 2, des schémas illustrant le transfert du masque ZnO dans le substrat ;
- la figure 3A, un schéma montrant les étapes du procédé de structuration dit direct selon un premier mode de réalisation ne faisant pas partie de l'invention ;
- la figure 3B, un schéma montrant les étapes du procédé de structuration dit indirect selon un deuxième mode de réalisation;
- la figure 4A, un schéma montrant les étapes d'un premier procédé de fabrication d'un masque auto-supporté selon l'invention;
- la figure 4B, un schéma montrant les étapes d'un deuxième procédé de fabrication d'un masque auto-supporté selon l'invnetion ;
- la figure 5, une photo d'un masque structuré, sur un substrat ;
- la figure 6, une photo d'un masque structuré sur un substrat lui-même structuré ; et
- la figure 7, une photo d'un substrat nano structuré dont les éléments des motifs présentent un fort rapport de forme.

Pour plus de clarté, les éléments identiques ou similaires sont repérés par des signes de référence identiques sur l'ensemble des figures.

### DESCRIPTION DETAILLEE D'UN MODE DE REALISATION

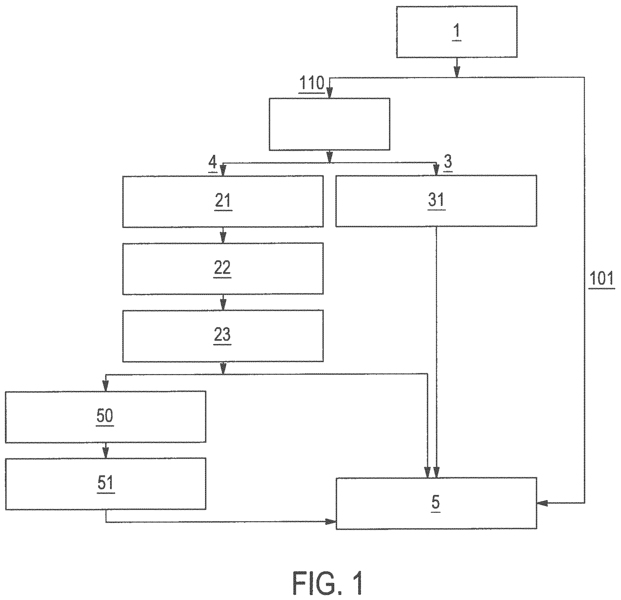

La figure 1 illustre par un organigramme le procédé en partie selon l'invention dans son ensemble. Un substrat 10 est utilisé, sur lequel on dépose une couche de ZnO 11, à priori d'épaisseur uniforme, de l'ordre du micromètre par exemple. C'est l'étape 1 commune aux différents modes de réalisation de l'invention. Si la couche de ZnO est déjà structurée alors on transfère directement dans le substrat ; c'est l'étape 101. Si la couche de ZnO n'est pas structurée (étape 110) alors on réalise sa structuration. Pour ce faire deux modes de réalisation sont envisageables. L'un 3 est appelé direct : on réalise une photodissolution du ZnO préférentiellement par une technique de lithographie interférentielle, étape 31.Une fois la couche de ZnO structurée obtenue, le transfert du motif en ZnO dans le substrat peut débuter. C'est l'étape 5 du procédé. On utilise avantageusement un masque nanostructuré de ZnO dont le taux de pulvérisation est par ailleurs faible.

Selon une variante, la structuration est dite indirecte (étape 4); les principales étapes sont représentées sur la partie gauche de la figure 1. Il s'agit essentiellement de déposer une résine photo ou électrosensible 12 sur la couche de ZnO 11, étape 21 ; puis de structurer ladite résine, étape 22 ; puis de transférer le motif dans le ZnO, étape 23.

A partir de là il est possible de transférer directement le masque ainsi structuré dans le substrat, étape 5.

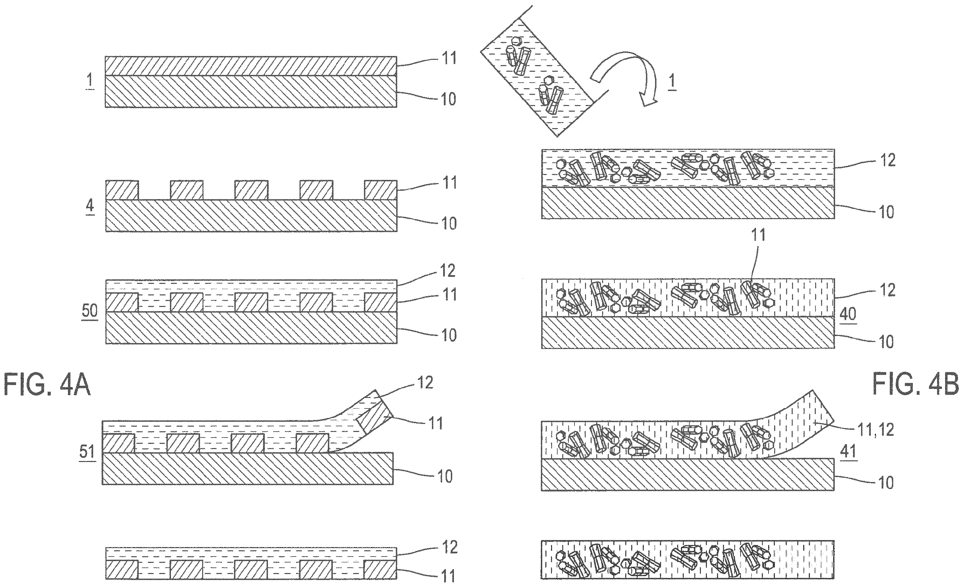

Selon l'invention, un masque autosupporté peut être formé : on réalise d'abord une infiltration du ZnO structuré par un polymère, étape 50 ; puis on sépare le masque vis-à-vis du premier substrat, étape 51. Enfin, on transfert le masque autosupporté dans un autre substrat, étape 5. Cette variante sera détaillée en relation avec les figures 4A et 4B.

Le transfert peut avoir lieu dans un substrat en Silicium, en verre, en quartz ou autre matériau. L'intérêt de l'invention se révèle pleinement lorsque des matériaux difficiles à graver sont visés.

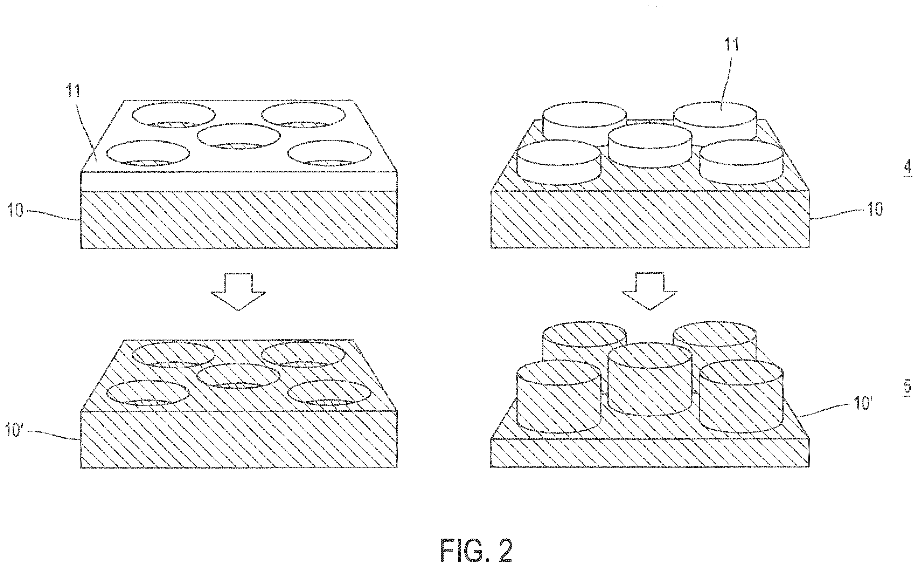

La figure 2 illustre le transfert en lui-même d'un masque de ZnO 11 dans un substrat 10, selon l'invention. Sur la partie gauche de la figure 2 est illustré le transfert d'une couche perforée de ZnO dans un substrat. Dans ce cas le substrat final présente des trous ou reliefs négatifs correspondant aux trous de ZnO dans le masque. Sur la partie droite de la figure 2 est représenté le transfert de reliefs positifs (plots) dans un substrat. Ici le substrat final 10' présente des reliefs positifs ou plots qui dépassent de sa surface principale. Bien entendu les deux versions font partie de l'invention.

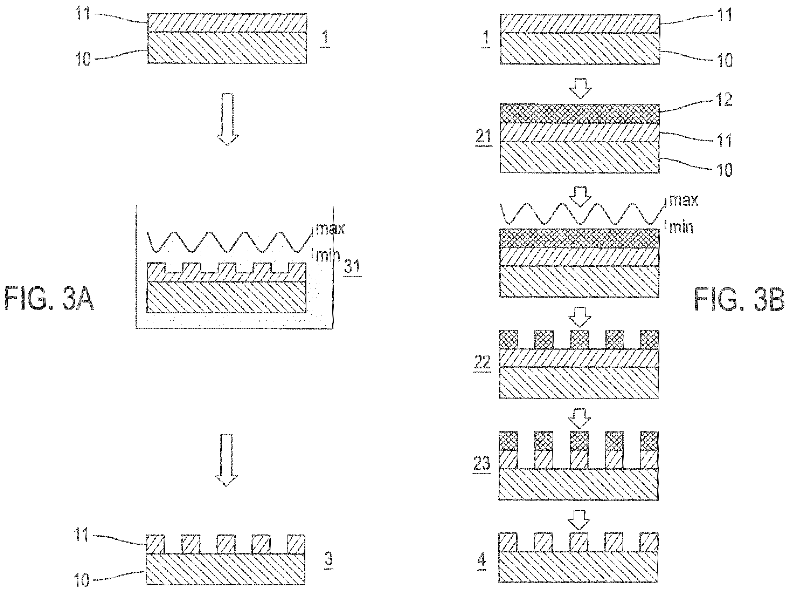

La figure 3A illustre les principales étapes du procédé de structuration dit direct, non partie à l'invention. La figure 3B concerne les étapes d'une structuration dite indirecte du ZnO.

La structuration directe selon la figure 3A comprend le dépôt d'une couche de ZnO 11 sur un substrat 10, étape 1 ; puis la photodissolution du ZnO préférentiellement par lithographie interférentielle, selon un motif donné. Un laser peut être utilisé à cet effet tandis que l'ensemble est immergé dans un bain de chlorure de sodium. A la fin de cette structuration, un masque final, structuré, est obtenu. Il sera ensuite transféré dans le substrat, étape 5 de la figure 2.

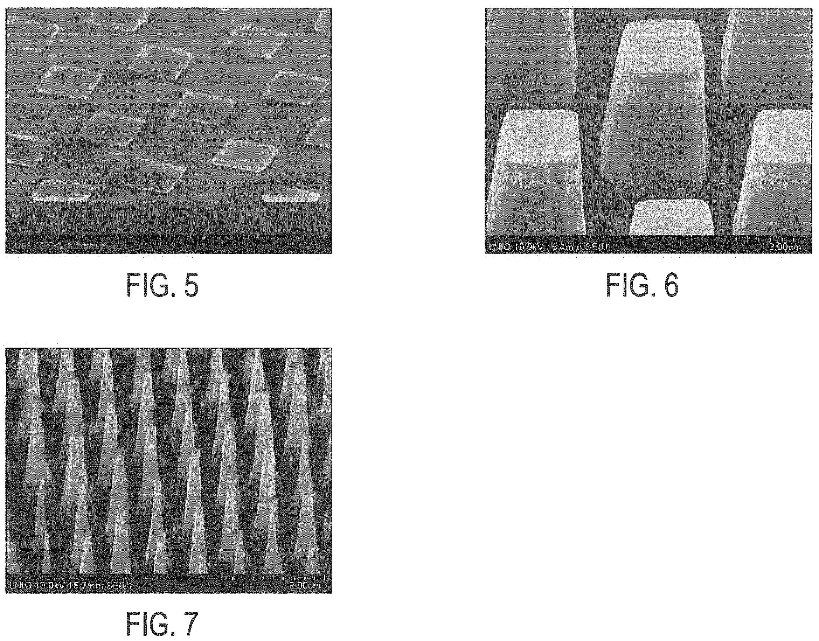

Pour la structuration indirecte illustrée par la figure 3B, on procède d'abord au dépôt d'une couche de ZnO 11 sur le substrat 10, étape 1. Puis sur la surface libre (non en contact avec le substrat) de la couche de ZnO 11, on dépose une couche d'une résine électro ou photosensible 12. C'est l'étape 21 du procédé. La couche de ZnO présente par exemple dans le cas de la figure 5 une épaisseur de l'ordre de 100 nanomètres ; la couche de résine a une épaisseur d'environ 1.4 micromètres.

On structure alors, étape 22, la résine électro ou photosensible 12. Ceci met à découvert certaines zones de ZnO. La structuration de la résine peut être réalisée par lithographie, de type électronique ou optique. L'homme de métier choisira en fonction des besoins et contraintes.

Ensuite, étape 23, certaines zones de ZnO étant découvertes (c'est-à-dire non recouvertes de résine), on opère une attaque chimique liquide afin de dissoudre ces zones de ZnO. On obtient ainsi un masque structuré comprenant du ZnO. Ce masque dit final est ultérieurement transféré dans le substrat.

Le taux de pulvérisation du ZnO étant faible, ceci permet de réaliser des structures à fort rapport de forme ou encore de structurer des matériaux habituellement difficiles à graver tels que le verre ou le cristal. Le rapport de forme est couramment défini comme le ratio entre la hauteur ou profondeur d'un élément d'un motif et sa plus grande dimension mesurée parallèlement au plan du substrat. Dans les exemples qui suivent, des valeurs de rapports de forme sont donnés à titres indicatif et comparatif.

L'étape 4 du procédé, correspondant à l'étape de structuration du ZnO, étant achevée, c'est le transfert du motif de ZnO dans le substrat qui est réalisé : étape 5. Différentes techniques de transfert peuvent être envisagées sans sortir du cadre de l'invention : par voie humide, par usinage ionique, par gravure ionique réactive, par gravure chimique liquide, ou toute technique fonctionnellement équivalente.

Les figures 4A et 4B illustrent l'élaboration d'un masque structuré et autosupporté de ZnO, qui peut ensuite être déposé sur n'importe quel substrat.

Selon la figure 4A on dépose d'abord une couche mince de ZnO 11 sur un premier substrat 10, étape 1 ; puis on structure le ZnO comme déjà évoqué, étape 4 ; puis on infiltre la couche de ZnO 11 ainsi structurée par une couche mince de polymère 12, étape 50 ; ensuite on sépare le ZnO inclut dans la couche de polymère vis-à-vis dudit premier substrat, étape 51. C'est ainsi que l'on obtient le masque autosupporté de ZnO qui est ici de forme et de dimension totalement contrôlées.

La figure 4B illustre le cas où l'on part de structures de ZnO dispersées dans une solution de résine formant ensemble une couche mince 12 que l'on dépose sur un premier substrat, étape 10. Puis, on durcit la résine, étape 40, dans des conditions connues en elles-mêmes et appropriées au cas d'espèce. Ensuite, on sépare la couche mince de résine vis-à-vis dudit substrat, étape 41. On obtient ainsi un masque autosupporté partiellement contrôlé puisque la disposition des (nano)structures de ZnO est aléatoire.

L'homme de métier choisira l'une ou l'autre de ces méthodes en fonction du cas de figure envisagé. Un tel masque autosupporté est donc une sorte de film transférable sur un substrat.

La figure 5 est une photographie correspondant à l'étape de structuration du masque en ZnO : on voit nettement le motif en ZnO (masque) qui émerge au-dessus de la surface plane du substrat.

La figure 6 montre l'étape suivante. Le transfert a eu lieu et l'on voit clairement un motif constitué du masque de ZnO en partie supérieure et du substrat structuré en partie inférieure. Des éléments de motifs sont ainsi crées. La figure 7 montre un exemple de structuration sur une grande surface, avec des éléments de motif identiques entre eux, en forme de cônes. Pour un tel exemple, la période du motif est ici de 1 micromètre. L'épaisseur de ZnO est d'environ 250 nm et la durée de gravure est de 15 minutes. La vitesse de la gravure verticale est la suivante : vitesse de la gravure du substrat : 153 nm/min ; vitesse de la gravure du masque : 15.5 nm/min. On obtient ainsi une sélectivité de 9.9 qui correspond au ratio de la vitesse du substrat sur la vitesse du masque ZnO. Sur un tel motif la dimension L est de 400 nm. La dimension L est la valeur de la plus grande longueur d'un élément de motif mesurée parallèlement au plan principal du substrat. La profondeur H d'un élément du motif est égale à environ 2.3 micromètre. On a donc un rapport de forme (H/L) égal à environ 5.75. Ce rapport, dit rapport de forme, est très intéressant car bien supérieur aux rapports de forme usuellement obtenus.

De façon connue, les rapports de forme obtenus pour des structurations à l'échelle nanométrique sont de l'ordre de 1 avec des résines traditionnelles, et de l'ordre de 5 en combinant des résines traditionnelles et une gravure cryogénique. L'obtention d'un rapport de forme supérieur nécessite généralement d'adapter la matière du masque en fonction du substrat à graver.

De façon particulièrement intéressante, le ZnO permet de structurer notamment à une échelle nanométrique de grandes surfaces de matériaux qu'il est usuellement difficile de travailler.

De façon inattendue, la capacité de résistance à la gravure à sec d'ions réactifs du ZnO ainsi que sa dissolution aisée par voie chimique liquide, en fait un masque particulièrement intéressant.

De nombreuses combinaisons peuvent être envisagées sans sortir du cadre de l'invention ; l'homme de métier choisira l'une ou l'autre en fonction des contraintes économiques, ergonomiques, dimensionnelles ou autres qu'il devra respecter.

## Revendications

1. Procédé de structuration haute résolution et de transfert d'un masque (11) dans un substrat, ledit masque (11) est constitué de ZnO structuré, ladite structuration du ZnO étant réalisée par lithographie et le transfert du ZnO dans le substrat étant réalisé par gravure sèche, **caractérisé en ce que** ledit masque est autosupporté au moyen de polymères et **en ce que** ledit procédé comprend les étapes consistant à : -préparer un masque autosupporté ; - disposer le masque autosupporté sur un substrat à structurer ; -transférer le masque autosupporté dans ledit substrat.

2. Procédé selon la revendication 1 **caractérisé en ce que** la préparation dudit masque autosupporté comprend les étapes suivantes: - (1) déposer une couche mince (11) constituée de ZnO sur un premier substrat (10) ; - (4) structurer ladite couche de ZnO ; - (50) infiltrer la couche de ZnO par une couche mince de polymère ; - (51) séparer ledit masque autosupporté vis-à-vis dudit premier substrat (10).

3. Procédé selon la revendication 1 **caractérisé en ce que** la préparation dudit masque autosupporté comprend les étapes suivantes: - (1) déposer une couche mince comprenant des nanostructures de ZnO (11) incluses dans un polymère (12), sur un premier substrat (10); - (40) faire durcir ledit polymère (12) ; - (41) séparer le masque autosupporté vis-à-vis du premier substrat (10).

4. Procédé selon l'une des revendications précédentes **caractérisé en ce que** ledit substrat est réalisé en un matériau tel que le Silicium, le quartz ou le verre.

5. Procédé selon la revendication 4, **caractérisé en ce que** le transfert est réalisé par gravure sèche fluorée dans du Silicium.

## Patentansprüche

1. Verfahren zur Hochauflösungsstrukturierung und zum Transfer einer Maske (11) in ein Substrat, wobei besagte Maske aus strukturiertem ZnO besteht, besagte Strukturierung des ZnO durch Lithographie erzielt wird und der Transfer des ZnO in das Substrat durch Trockenätzung erfolgt, **dadurch gekennzeichnet, dass** besagte Maske aufgrund von Polymeren selbsttragend ist und dadurch, dass besagtes Verfahren Schritte umfasst, die darin bestehen: eine selbsttragende Maske vorzubereiten; - die selbsttragende Maske auf einem zu strukturierenden Substrat anzuordnen; die selbsttragende Maske in besagtes Substrat zu transferieren.

2. Verfahren nach Anspruch 1, **dadurch gekennzeichnet, dass** die Vorbereitung besagter selbsttragender Maske die folgenden Schritte umfasse: - (1) das Auftragen einer dünnen ZnO-Schicht (11) auf ein erstes Substrat (10); (4) das Strukturieren besagter ZnO-Schicht; (50) das Einsickern der ZnO-Schicht durch eine dünne Polymerschicht hindurch; (51) das Lösen besagter selbsttragender Maske von besagtem ersten Substrat (10).

3. Verfahren nach Anspruch 1, **dadurch gekennzeichnet, dass** die Vorbereitung der besagten selbsttragenden Maske die folgenden Schritte umfasst: - (1) das Auftragen einer dünnen Schicht mit ZnO-Nanostrukturen (11), die in einem Polymer (12) eingebettet sind, auf einem ersten Substrat (10); - (40) das Härten des besagten Polymers (12); - (41) das Lösen der selbsttragenden Maske von besagtem ersten Substrat (10).

4. Verfahren nach einem der vorhergehenden Ansprüche, **dadurch gekennzeichnet, dass** besagtes Substrat aus einem Material wie Silicium, Quarz oder Glas hergestellt wird.

5. Verfahren nach Anspruch 4, **dadurch gekennzeichnet dass** der Transfer durch fluorierte Trockenätzung in Silicium erfolgt.

## Claims

1. A method for the high-resolution structuring and transferring of a mask (11) into a substrate; with said mask consisting of structured ZnO, with said structuring of ZnO being performed using lithography and transferring of ZnO into the substrate being performed by dry etching, **characterized in that** said mask is self-supported using polymers and **in that** the method comprises the steps consisting in: - preparing a self-supported mask; - positioning said self-supported mask on a substrate to be structured; - transferring the self-supported mask into said substrate.

2. A method according to claim 1, **characterized in that** the preparation of said self-supported mask comprises the following steps: - (1) depositing a thin layer (11) consisting of ZnO onto a first substrate (10); - (4) structuring said ZnO layer; - (50) letting the ZnO layer be infiltrated by a thin layer of polymer; - (51) separating said self-supported mask from said first substrate (10).

3. A method according to claim 1, **characterized in that** the preparation of said self-supported mask comprises the following steps: - (1) depositing a thin layer comprising ZnO nanostructures (11) included in a polymer (12), onto a first substrate (10); - (40) curing said polymer (12); - (41) separating the self-supported mask from the first substrate (10).

4. A method according to one of the preceding claims, **characterized in that** said substrate is made of a material such as silicon, quartz or glass.

5. A method according to claim 4, **characterized in that** transferring is performed using fluorinated dry etching in silicon.
